# EUROPEAN PATENT APPLICATION

(11) **EP 2 684 931 A1**
(43) Date of publication of application: **15.01.2014**
(21) Application number: 12758273.2
(22) Date of filing: 23.02.2012
(51) Int. Cl.: C09K 3/10, B32B 27/00, B32B 27/32, B32B 27/40, H01L 31/042

(54) **HEAT SEALANT, AND LAMINATE AND SOLAR-CELL MODULE USING SAME**

(30) Priority: 11.03.2011 JP 2011054301
(71) Applicant: DIC Corporation, Tokyo 174-8520 (JP)
(72) Inventor: KURIYAMA Chisato, Takaishi-shi Osaka 592-0001 (JP); CHIYONOBU Kazuhiko, Takaishi-shi Osaka 592-0001 (JP); KITADA Mitsuru, Takaishi-shi Osaka 592-0001 (JP)
(74) Representative: Albrecht, Thomas
(86) International application number: PCT/JP2012/054359
(87) International publication number: WO 2012/124445

(57) **Abstract**

An object of the present invention is to provide an aqueous resin composition that can form a cured resin layer that exhibits high adhesion to a base member and high moisture-heat resistance. The present invention relates to a heat-sealing material including an aqueous urethane resin (A), an aqueous polyolefin resin (B), a cross-linking agent (C), and an aqueous medium (D), wherein the cross-linking agent (C) contains an alkylated methylolmelamine resin (c1) and an epoxy compound (c2); a content of the alkylated methylolmelamine resin (c1) is in a range of 5% by mass to 50% by mass; one or both of the aqueous urethane resin (A) and the aqueous polyolefin resin (B) have a functional group [X] that is capable of reacting with an epoxy group; and a ratio of an amount of substance of an epoxy group of the epoxy compound (c2) to a total amount of substance of the functional group [X] is 5/1 to 1/5.

## Description

### Technical Field

The present invention relates to a heat-sealing material that can be used for bonding of various members, for example, bonding of the back sheet layer of a solar-cell module. In particular, the present invention relates to a heat-sealing material that can be used for bonding together a polar member and a nonpolar member.

### Background Art

As for members used for producing automobile parts, household electrical appliances, solar photovoltaic power generation apparatuses, and the like, members have been widely used that are formed of ethylene-vinyl acetate resins, polyolefin resins, and the like that are excellent in terms of resistance to weather, water, and the like and are excellent in terms of formability and recyclability.

In general, such an ethylene-vinyl acetate resin tends to be deteriorated upon exposure to heat, water (moisture), or the like and is insufficient in terms of moisture-heat resistance. For this reason, a member formed of the ethylene-vinyl acetate resin is usually laminated to a glass, a polyethylene terephthalate base member, or the like to provide a composite member. Thus, moisture-heat resistance that is sufficient to suppress the deterioration is often imparted to the ethylene-vinyl acetate resin base member.

However, in general, a base member formed of an ethylene-vinyl acetate resin or the like has a low surface polarity. Accordingly, for example, even when the ethylene-vinyl acetate resin base member or the like is bonded to the glass or the like with an adhesive, separation at the interface between the surface of the ethylene-vinyl acetate resin base member or the like and the adhesive layer easily occurs; or, after temporary achievement of bonding, the adhesive layer is deteriorated due to influences of heat, water, and the like and separation is caused after the lapse of time in some cases.

On the other hand, by adjusting the composition of the adhesive, the adhesion to a nonpolar base member formed of the ethylene-vinyl acetate resin or the like can be enhanced. However, when the nonpolar base member is bonded to a base member that is a polar base member such as the glass or the polyethylene terephthalate base member, the adhesion between the polar base member and the adhesive layer is decreased and separation is still caused after the lapse of time in some cases.

As described above, it has been technically difficult to find an adhesive that exhibits high adhesion to both of a nonpolar base member and a polar base member.

A known adhesive that exhibits high adhesion is, for example, an adhesive composed of an aqueous dispersion containing, at specific proportions, an acid-modified polyolefin resin, a polyurethane resin, a fatty acid amide, and a terpene-based tackifier in an aqueous medium. It is known that such an adhesive exhibits high adhesion to thermoplastic resin base members (for example, refer to Patent Literature 1).

However, this adhesive is not the above-described adhesive that exhibits high adhesion to both of a nonpolar base member and a polar base member. Accordingly, in some cases, separation is caused at an interface between one of the base members and the adhesive layer after the lapse of time.

In addition, this adhesive tends to be deteriorated due to exposure to heat, water (moisture), or the like and hence deterioration or separation of the adhesive layer is caused due to influences of heat, water, or the like after the lapse of time. As a result, in some cases, deterioration of the base members themselves is also caused.

In general, base members are often bonded together with such an adhesive by the following procedure: immediately before the bonding is performed, the adhesive is applied to a surface of one of the base members; and, before the adhesive layer is completely cured, on the surface of the adhesive layer having tackiness, the other base member is then placed and the adhesive layer is cured to thereby bond the base members together.

However, such a procedure requires operations such as application of the adhesive and removal of a solvent contained in the adhesive on the operation site where the base members are bonded together. For this reason, the production efficiency of the composite member is considerably decreased in some cases.

### Citation List

### Patent Literature

PTL 1: Japanese Unexamined Patent Application Publication No. 2009-235289

### Summary of Invention

### Technical Problem

An object of the present invention is to provide, for example, a heat-sealing material that exhibits high adhesion to both of a polar base member and a nonpolar base member and that can form a heat-sealing layer having such moisture-heat resistance that suppresses a decrease in the adhesion due to influences of heat, water (moisture), and the like.

Another object of the present invention is to provide, for example, a heat-sealing material that exhibits high adhesion to both of a polar base member and a nonpolar base member, that can form a heat-sealing layer having such moisture-heat resistance that suppresses deterioration and a decrease in the adhesion due to influences of heat, water (moisture), and the like, and that can bond base members together by the following procedure: the heat-sealing material is applied to a surface of one of the base members and dried to form a cross-linked heat-sealing layer in advance; and the other base member is then placed on the heat-sealing layer and heating is performed. Solution to Problem

The inventors of the present invention performed studies on how to achieve the objects. The inventors performed studies on the basis of a resin composition that is a combination of an aqueous urethane resin (A) and an aqueous polyolefin resin (B). The inventors examined combinations between the resin composition and various cross-linking agents that can be used in combination with the resin composition.

As a result, the inventors have found that, when the resin composition is combined with a specific melamine resin as an essential component and an epoxy compound, unexpectedly, a heat-sealing layer can be formed without degradation of adhesion to base members, the heat-sealing layer not being deteriorated by influences of heat, water, and the like.

That is, the present invention relates to a heat-sealing material including an aqueous urethane resin (A), an aqueous polyolefin resin (B), a cross-linking agent (C), and an aqueous medium (D), wherein the cross-linking agent (C) contains an alkylated methylolmelamine resin (c1) and an epoxy compound (c2); a content of the alkylated methylolmelamine resin (c1) with respect to a total mass of the aqueous urethane resin (A) and the aqueous polyolefin resin (B) is in a range of 5% by mass to 50% by mass; one or both of the aqueous urethane resin (A) and the aqueous polyolefin resin (B) have a functional group [X] that is capable of reacting with an epoxy group; and a ratio of an amount of substance of an epoxy group of the epoxy compound (c2) to a total amount of substance of the functional group [X] [amount of substance of epoxy group/total amount of substance of functional group [X]] is 5/1 to 1/5. Advantageous Effects of Invention

A heat-sealing material according to the present invention exhibits high adhesion not only to base members formed of ethylene-vinyl acetate resins and polyolefin resins, which are widely used in industry, but also to base members formed of polyethylene terephthalate and the like. Accordingly, the heat-sealing material can be used for, for example, bonding together of various nonpolar base members and polar base members, and formation of surface coatings on such base members.

In addition, use of a heat-sealing material according to the present invention can considerably increase the production efficiency of laminated bodies (composite members) that are formed by laminating various base members, in particular, solar-cell modules.

### Description of Embodiments

A heat-sealing material according to the present invention includes an aqueous urethane resin (A), an aqueous polyolefin resin (B), a cross-linking agent (C), and an aqueous medium (D), wherein the cross-linking agent (C) contains an alkylated methylolmelamine resin (c1) and an epoxy compound (c2); a content of the alkylated methylolmelamine resin (c1) with respect to a total mass of the aqueous urethane resin (A) and the aqueous polyolefin resin (B) is in a range of 5% by mass to 50% by mass; one or both of the aqueous urethane resin (A) and the aqueous polyolefin resin (B) have a functional group [X] that is capable of reacting with an epoxy group; and a ratio of an amount of substance of an epoxy group of the epoxy compound (c2) to a total amount of substance of the functional group [X] [amount of substance of epoxy group/total amount of substance of functional group [X]] is in a range of 5/1 to 1/5.

The alkylated methylolmelamine resin (c1) can form a cross-linking structure by a self-cross-linking reaction. In addition, when the functional group [X] of the aqueous urethane resin (A) and the aqueous polyolefin resin (B) reacts with the epoxy compound (c2) to form a functional group such as a hydroxyl group, this hydroxyl group reacts with the alkylated methylolmelamine resin (c1) to form a cross-linking structure.

The alkylated methylolmelamine resin (c1) is used such that the content thereof with respect to the total mass of the aqueous urethane resin (A) and the aqueous polyolefin resin (B) is in the range of 5% by mass to 50% by mass. As a result, moisture-heat resistance that is high enough to suppress deterioration of the heat-sealing layer and a decrease in the adhesion of the heat-sealing layer in spite of the influences of heat, water (moisture), and the like and high adhesion to various base members can be achieved.

On the other hand, when the content of the alkylated methylolmelamine resin (c1) with respect to the total mass of the aqueous urethane resin (A) and the aqueous polyolefin resin (B) is, for example, 3% by mass, the moisture-heat resistance may become low. When the content is 55% by mass, the moisture-heat resistance may become low and a decrease in the adhesion to various base members may also be caused.

The alkylated methylolmelamine resin (c1) is preferably used such that the content thereof with respect to the total mass of the aqueous urethane resin (A) and the aqueous polyolefin resin (B) is in the range of 10% by mass to 30% by mass, so that higher moisture-heat resistance and high adhesion to various base members can be achieved.

On the other hand, the epoxy compound (c2) reacts with the functional group [X], which is present in one or both of the aqueous urethane resin (A) and the aqueous polyolefin resin (B), to form a cross-linking structure. As a result, the epoxy compound (c2) is used to impart high moisture-heat resistance and high adhesion to various base members. That is, in the present invention, use of the alkylated methylolmelamine resin (c1) only as the cross-linking agent (C) does not allow achievement of an object of the present invention. Even when the alkylated methylolmelamine resin (c1) only is used as the cross-linking agent (C), in some cases, it is difficult to achieve high moisture-heat resistance and high adhesion to various base members.

In addition, it is not sufficient to simply combine the alkylated methylolmelamine resin (c1) and the epoxy compound (c2) as the cross-linking agent (C). Specifically, the epoxy compound (c2) is used such that the ratio of the amount of substance (number of moles) of the epoxy group of the epoxy compound (c2) to the total amount of substance (number of moles) of the functional group [X] in the aqueous urethane resin (A) and the aqueous polyolefin resin (B) [amount of substance (number of moles) of epoxy group/total amount of substance (number of moles) of functional group [X]] is in the range of 5/1 to 1/5.

As a result, a heat-sealing layer can be formed that has a higher cross-linking density achieved by curing caused by heating or the like. Accordingly, high moisture-heat resistance and high adhesion to various base members can be achieved to thereby suppress deterioration of the heat-sealing layer and a decrease in the adhesion of the heat-sealing layer in spite of the influences of heat, water (moisture), and the like.

Here, when the usage ratio of the epoxy compound (c2) [amount of substance of epoxy group/total amount of substance of functional group [X]] is 6/1, the adhesion to various base members may be decreased in some cases. When the usage ratio is 1/6, durability such as moisture-heat resistance may be degraded in some cases.

The usage ratio [amount of substance of epoxy group/total amount of substance of functional group [X]] is preferably in the range of 2/1 to 1/3, so that higher moisture-heat resistance and high adhesion to various base members can be achieved.

In addition, in order to achieve higher moisture-heat resistance and high adhesion to various base members, the alkylated methylolmelamine resin (c1) and the epoxy compound (c2) are preferably used with a mass ratio [the alkylated methylolmelamine resin (c1)/the epoxy compound (c2)] being in the range of 7/1 to 1/4, more preferably in the range of 5/1 to 1/4.

In addition, regarding the aqueous urethane resin (A) and the aqueous polyolefin resin (B) that are used in combination with the cross-linking agent (C), a resin is used that has the functional group [X] that is capable of reacting with, in particular, in the cross-linking agent (C), a functional group of the epoxy compound (c2). Specifically, this functional group of the epoxy compound (c2) is a hydrolyzable silyl group such as an epoxy group, an alkoxy silyl group, or a silanol group.

The functional group [X] is, for example, a carboxyl group, a hydroxyl group, or an amino group. In particular, a carboxyl group is preferred.

Note that, when a urethane resin or a polyolefin resin having a hydrophilic group such as an anionic group or a cationic group is used to achieve stability of the aqueous urethane resin (A) and the aqueous polyolefin resin (B) present in the aqueous medium (D), the hydrophilic group such as a carboxyl group or a carboxylate group also functions as the functional group [X] during the cross-linking reaction and can react with a part of the cross-linking agent (C).

In particular, when a carboxyl group is used as the functional group [X], the aqueous urethane resin (A) preferably has an acid value of 10 to 70, more preferably an acid value of 10 to 50, and preferably an acid value of 10 to 35 in view of an increase in the adhesion to various base members.

The aqueous polyolefin resin (B) preferably has an acid value of 5 to 300, more preferably an acid value of 10 to 250.

The aqueous urethane resin (A) and the aqueous polyolefin resin (B) are preferably independently dispersed or dissolved in the aqueous medium (D). However, portions of these resins may be bonded to form resin particles, that is, so-called core-shell composite resin particles may be formed.

In particular, the aqueous urethane resin (A) and the aqueous polyolefin resin (B) preferably independently form resin particles and can be dispersed in the aqueous medium (D).

The resin particles preferably have an average particle size in the range of about 10 nm to about 500 nm in view of enhancement of the smoothness of a coating film to be formed. Here, the average particle size denotes an average particle size that is measured by dynamic light scattering and is based on volume.

The mass ratio of the aqueous urethane resin (A) and the aqueous polyolefin resin (B) [aqueous urethane resin (A)/aqueous polyolefin resin (B)] is preferably in the range of 9/1 to 2/8, more preferably in the range of 8/2 to 3/7, still more preferably in the range of 8/2 to 5/5 in view of achievement of higher moisture-heat resistance and high adhesion to various base members.

In addition, the content of the aqueous urethane resin (A) and the aqueous polyolefin resin (B) with respect to the total mass of a heat-sealing material according to the present invention is preferably in the range of 5% by mass to 70% by mass in view of maintaining of high dispersion stability and coating workability of the heat-sealing material.

In addition, the aqueous urethane resin (A) and the aqueous polyolefin resin (B) may include a hydrophilic group in view of imparting of high dispersion stability in the aqueous medium (D). The hydrophilic group may be, for example, an anionic group, a cationic group, or a nonionic group. In particular, an anionic group is preferably used.

The anionic group may be, for example, a carboxyl group, a carboxylate group, a sulfonic group, or a sulfonate group. In particular, use of a carboxylate group or a sulfonate group formed by partial or entire neutralization with a basic compound or the like is preferred in view of production of an aqueous resin having high dispersibility in water.

The cationic group may be, for example, a tertiary amino group or a group provided by neutralizing a tertiary amino group with an acid compound or a quaternizing agent.

The nonionic group may be, for example, a polyoxyalkylene group such as a polyoxyethylene group, a polyoxypropylene group, a polyoxybutylene group, a poly(oxyethylene-oxypropylene) group, or a polyoxyethylene-polyoxypropylene group.

The aqueous urethane resin (A) has the functional group [X] and is used to obtain a heat-sealing material that can form a heat-sealing layer having high moisture-heat resistance and high adhesion to various base members.

In view of imparting high adhesion to a polar base member and a nonpolar base member and durability, the aqueous urethane resin (A) preferably has a weight-average molecular weight in the range of 5,000 to 200,000, more preferably in the range of 5,000 to 100,000.

In addition, regarding the aqueous urethane resin (A), in view of further enhancing the adhesion to a polar base member that has high surface polarity and is formed of polyethylene terephthalate or the like, the aromatic-ring-structure content with respect to the entirety of the aqueous urethane resin (A) is preferably in the range of 200 mmol/kg to 9,000 mmol/kg, more preferably in the range of 350 mmol/kg to 8,000 mmol/kg.

The aqueous urethane resin (A) may be produced by, for example, a reaction between a polyol (a1) and a polyisocyanate (a2), and optionally a chain extender.

The polyol (a1) may be, for example, a polyester polyol, a polycarbonate polyol, a polyether polyol, or a polyolefin polyol; and these may be used alone or in combination of two or more thereof.

In particular, a polyester polyol or a polycarbonate polyol is preferably used. More preferably, an aromatic-structure-containing polyester polyol or a polycarbonate polyol is used.

The aromatic-structure-containing polyester polyol is preferably used in order to enhance the adhesion to a polar base member that has high surface polarity and is formed of polyethylene terephthalate or the like. On the other hand, the polycarbonate polyol is preferably used in order to impart durability that is sufficient to suppress, for example, deterioration of a polyethylene terephthalate base member or the like.

The polyester polyol may be, for example, a polyester polyol that is obtained by an esterification reaction between a low-molecular-weight polyol and a polycarboxylic acid, a polyester that is obtained by a ring-opening polymerization reaction of a cyclic ester compound such as ε-caprolactone, or a copolymer polyester of the foregoing.

The low-molecular-weight polyol may be, for example, a polyol having a molecular weight of about 50 to about 300. Examples of the polyol include aliphatic polyols such as ethylene glycol, propylene glycol, 1,4-butanediol, 1,6-hexanediol, diethylene glycol, neopentyl glycol, and 1,3-butanediol; alicyclic-structure-containing polyols such as cyclohexanedimethanol; and aromatic-structure-containing polyols including bisphenol compounds such as bisphenol A and bisphenol F and alkylene oxide adducts of the foregoing.

Examples of the polycarboxylic acid that can be used for producing the polyester polyol include aliphatic polycarboxylic acids such as succinic acid, adipic acid, sebacic acid, and dodecane dicarboxylic acid; aromatic polycarboxylic acids such as terephthalic acid, isophthalic acid, phthalic acid, and naphthalene dicarboxylic acid; anhydrides of the foregoing; and ester-forming derivatives of the foregoing.

The aromatic-structure-containing polyester polyol that can be used as the polyester polyol can be produced, for example, from the above-described combination of a low-molecular-weight polyol and a polycarboxylic acid, one or both of which have an aromatic structure.

Specifically, the aromatic-structure-containing polyester polyol is preferably obtained by a reaction between an aliphatic polyol such as ethylene glycol, diethylene glycol, or 1,4-butanediol and an aromatic polycarboxylic acid such as terephthalic acid, isophthalic acid, or phthalic acid. Alternatively, the aromatic-structure-containing polyester polyol can be produced by a reaction between an aromatic-structure-containing polyol such as bisphenol A and the above-described aliphatic polycarboxylic acid.

Regarding the aromatic-structure-containing polyester polyol, in particular, in view of enhancing the adhesion to a polar base member, the aromatic-ring-structure content with respect to the total weight of the aromatic-structure-containing polyester polyol is preferably in the range of 300 mmol/Kg to 10,000 mmol/Kg for the purpose of enhancing the adhesion to a polar base member having high surface polarity represented by a polyethylene terephthalate base member without degradation of high moisture-heat resistance.

The polyester polyol preferably has a number-average molecular weight in the range of 200 to 5,000. In particular, the aromatic-structure-containing polyester polyol preferably has a number-average molecular weight in the range of 250 to 3,000 for the purpose of enhancing the adhesion to a polar base member having high surface polarity represented by a polyethylene terephthalate base member without degradation of high moisture-heat resistance.

The content of the polyester polyol, preferably an aromatic-structure-containing polyester polyol, is preferably in the range of 10% by mass to 90% by mass with respect to the total mass of the polyol (a1) and the polyisocyanate (a2) that are used for producing the aqueous urethane resin (A) used in the present invention for the purpose of enhancing the adhesion to a polar base member having high surface polarity represented by a polyethylene terephthalate base member without degradation of high moisture-heat resistance.

The polycarbonate polyol that can be used as the polyol (a1) may be, for example, a polycarbonate polyol that can be obtained by a reaction between a carbonic acid ester and a polyol or a polycarbonate polyol that can be obtained by a reaction between phosgene and bisphenol A or the like.

The carbonic acid ester may be methyl carbonate, dimethyl carbonate, ethyl carbonate, diethyl carbonate, cyclo carbonate, diphenyl carbonate, or the like.

The polyol that can react with such a carbonic acid ester may be, for example, a diol having a relatively low molecular weight of about 50 to about 2,000 such as ethylene glycol, diethylene glycol, 1,2-propylene glycol, dipropylene glycol, 1,4-butanediol, 1,5-pentanediol, 3-methyl-1,5-pentanediol, 1,4-cyclohexanediol, 1,6-hexanediol, or cyclohexane dimethanol; or a polyester polyol such as polyethylene glycol, polypropylene glycol, or polyhexamethylene adipate.

In particular, the polycarbonate polyol is preferably obtained by a reaction between a carbonic acid ester and one or more of 1,4-butanediol, 1,5-pentanediol, and 1,6-hexanediol for the purpose of imparting adhesion to a nonpolar base member formed of an ethylene-vinyl acetate resin, polypropylene, or the like.

The polycarbonate polyol preferably has a number-average molecular weight in the range of 500 to 4,000 for the purpose of imparting adhesion to a nonpolar base member formed of an ethylene-vinyl acetate resin, polypropylene, or the like without degradation of high moisture-heat resistance.

The content of the polycarbonate polyol is preferably in the range of 10% by mass to 90% by mass with respect to the total mass of the polyol (a1) and the polyisocyanate (a2) that are used for producing the aqueous urethane resin (A) used in the present invention for the purpose of imparting adhesion to a nonpolar base member formed of an ethylene-vinyl acetate resin, polypropylene, or the like without degradation of high moisture-heat resistance.

The polyether polyol that can be used as the polyol (a1) may be, for example, a polyether polyol that is obtained by addition polymerization of alkylene oxide with, as an initiator, one or more compounds having two or more active hydrogen atoms.

The initiator may be, for example, ethylene glycol, diethylene glycol, triethylene glycol, propylene glycol, trimethylene glycol, 1,3-butanediol, 1,4-butanediol, 1,6-hexanediol, bisphenol A, glycerin, trimethylolethane, or trimethylol propane.

The alkylene oxide may be, for example, ethylene oxide, propylene oxide, butylene oxide, styrene oxide, epichlorohydrin, or tetrahydrofuran.

The polyolefin polyol that can be used as the polyol (a1) may be, for example, polyethylene polyol, polypropylene polyol, polyisobutene polyol, hydrogenated polybutadiene polyol, or hydrogenated polyisoprene polyol.

Regarding the polyol (a1), in view of imparting high dispersion stability in water to the aqueous urethane resin (A), those described above may be used in combination with a hydrophilic-group-containing polyol.

The hydrophilic-group-containing polyol may be, for example, other than the above-described polyols, an anionic-group-containing polyol, a cationic-group-containing polyol, or a nonionic-group-containing polyol. In particular, an anionic-group-containing polyol or a cationic-group-containing polyol is preferably used. More preferably, an anionic-group-containing polyol is used.

The anionic-group-containing polyol may be, for example, a carboxyl-group-containing polyol or a sulfonic-group-containing polyol.

The carboxyl-group-containing polyol may be, for example, 2,2'-dimethylolpropionic acid, 2,2'-dimethylolbutanoic acid, 2,2'-dimethylolbutyric acid, or 2,2'-dimethylolvaleric acid. In particular, 2,2'-dimethylolpropionic acid is preferably used. Carboxyl-group-containing polyester polyols that are obtained by reactions between the carboxyl-group-containing polyol and various polycarboxylic acids can also be used.

Examples of the sulfonic-group-containing polyol include polyester polyols that are obtained by reactions between dicarboxylic acids such as 5-sulfoisophthalic acid, sulfoterephthalic acid, 4-sulfophthalic acid, and 5[4-sulfophenoxy]isophthalic acid, or salts of the foregoing, and the low-molecular-weight polyols described as examples of polyols that can be used for producing the aromatic-structure-containing polyester polyol (a2).

The carboxyl-group-containing polyol or the sulfonic-group-containing polyol is preferably used such that the urethane resin (C) has an acid value in the range of 10 to 70, more preferably in the range of 10 to 50, still more preferably in the range of 10 to 35. Note that such an acid value in the present invention is a theoretical value calculated on the basis of the amount of an acid-group-containing compound such as a carboxyl-group-containing polyol used for producing the urethane resin (C).

It is preferred that the anionic group be partially or entirely neutralized with a basic compound or the like for the purpose of exhibiting high dispersibility in water.

Examples of the basic compound that can be used for neutralization of the anionic group include ammonia; organic amines having a boiling point of 200°C or more such as triethylamine, morpholine, monoethanolamine, and diethylethanolamine; and metal hydroxides such as NaOH, KOH, and LiOH. The basic compound is preferably used such that, in view of enhancement of the water dispersion stability of the resultant coating material, a molar ratio of basic compound/anionic group is in the range of 0.5 to 3.0, more preferably in the range of 0.9 to 2.0.

The above-described cationic-group-containing polyol may be, for example, a tertiary-amino-group-containing polyol. Specifically, for example, N-methyl-diethanolamine or a polyol obtained by a reaction between a compound having two epoxies in a single molecule and a secondary amine can be used.

It is preferred that the cationic group be partially or entirely neutralized with an acidic compound such as formic acid, acetic acid, propionic acid, succinic acid, glutaric acid, tartaric acid, or adipic acid.

In addition, a tertiary amino group serving as the cationic group may be partially or entirely quaternized. The quaternizing agent may be, for example, dimethyl sulfate, diethyl sulfate, methyl chloride, or ethyl chloride; and dimethyl sulfate is preferably used.

The nonionic-group-containing polyol may be, for example, a polyalkylene glycol having a constitutional unit derived from ethylene oxide.

The hydrophilic-group-containing polyol is preferably used in the range of 0.3% by mass to 10.0% by mass with respect to the total mass of the polyol (a1) used for producing the aqueous urethane resin (A).

Regarding the polyol (a1), in addition to the above-described polyols, if necessary, another polyol may be used.

The other polyol may be, for example, a polyol having a relatively low molecular weight such as ethylene glycol, diethylene glycol, 1,2-propylene glycol, dipropylene glycol, 1,4-butanediol, 1,5-pentanediol, 3-methyl-1,5-pentanediol, 1,4-cyclohexanediol, 1,6-hexanediol, or cyclohexanedimethanol.

The polyisocyanate (a2) that can react with the polyol (a1) may be, for example, an aromatic polyisocyanate such as 4,4'-diphenylmethane diisocyanate, 2,4'-diphenylmethane diisocyanate, carbodiimide-modified diphenylmethane diisocyanate, crude diphenylmethane diisocyanate, phenylene diisocyanate, tolylene diisocyanate, or naphthalene diisocyanate; an aliphatic polyisocyanate such as hexamethylene diisocyanate, lysine diisocyanate, xylylene diisocyanate, or tetramethylxylylene diisocyanate; or an alicyclic-structure-containing polyisocyanate such as cyclohexane diisocyanate, dicyclohexylmethane diisocyanate, or isophorone diisocyanate.

The aqueous urethane resin (A) can be produced in the following manner: for example, the reaction between the polyol (a1) and the polyisocyanate (a2) is caused in the absence of solvents or in the presence of an organic solvent to produce an aqueous urethane resin; subsequently, when the urethane resin has a hydrophilic group, the resin in which the hydrophilic group is partially or entirety neutralized, if necessary, is mixed with the aqueous medium (D) to provide an aqueous composition and, at this time, a chain extender is also mixed, if necessary, to cause a reaction.

The reaction between the polyol (a1) and the polyisocyanate (a2) is preferably caused such that, for example, the equivalent ratio of the isocyanate groups of the polyisocyanate (a2) to the hydroxyl groups of the polyol (a1) is in the range of 0.8 to 2.5, more preferably in the range of 0.9 to 1.5.

Examples of the organic solvent that can be used in the production of the aqueous urethane resin (A) include ketones such as acetone and methyl ethyl ketone; ethers such as tetrahydrofuran and dioxane; acetic acid esters such as ethyl acetate and butyl acetate; nitriles such as acetonitrile; and amides such as dimethylformamide and N-methylpyrrolidone. These organic solvents may be used alone or in combination of two or more thereof.

In the production of the aqueous urethane resin (A) used in the present invention, a chain extender may be used for the purpose of further enhancing the adhesion of a heat-sealing material according to the present invention to a polar base member or a nonpolar base member.

The chain extender that can be used in the production of the aqueous urethane resin (A) may be, for example, a polyamine or another active-hydrogen-atom-containing compound.

Examples of the polyamine include diamines such as ethylenediamine, 1,2-propanediamine, 1,6-hexamethylenediamine, piperazine, 2,5-dimethylpiperazine, isophoronediamine, 4,4'-dicyclohexylmethanediamine, 3,3'-dimethyl-4,4'-dicyclohexylmethanediamine, and 1,4-cyclohexanediamine; N-hydroxymethylaminoethylamine, N-hydroxyethylaminoethylamine, N-hydroxypropylaminopropylamine, N-ethylaminoethylamine, N-methylaminopropylamine; diethylenetriamine, dipropylenetriamine, triethylenetetramine; hydrazine, N,N'-dimethylhydrazine, 1,6-hexamethylenebishydrazine; succinic acid dihydrazide, adipic acid dihydrazide, glutaric acid dihydrazide, sebacic acid dihydrazide, isophthalic acid dihydrazide; β-semicarbazide propionic acid hydrazide, 3-semicarbazide-propyl-carbazate, and semicarbazide-3-semicarbazidemethyl-3,5,5-trimethylcyclohexane; and, ethylenediamine is preferably used.

Examples of the other active-hydrogen-containing compound include glycols such as ethylene glycol, diethylene lycol, triethylene glycol, propylene glycol, 1,3-propanediol, 1,3-butanediol, 1,4-butanediol, hexamethylene glycol, saccharose, methylene glycol, glycerin, and sorbitol; phenols such as bisphenol A, 4,4'-dihydroxydiphenyl, 4,4'-dihydroxydiphenyl ether, 4,4'-dihydroxydiphenyl sulfone, hydrogenated bisphenol A, and hydroquinone; and water. These compounds may be used alone or in combination of two or more thereof as long as the storage stability of a coating material according to the present invention is not degraded.

The chain extender is preferably used such that, for example, the equivalent ratio between the amino groups of a polyamine and excess isocyanate groups is in the range of 1.9 or less (equivalent ratio), more preferably in the range of 0.3 to 1.0 (equivalent ratio).

The aqueous urethane resin (A) produced by the above-described method can be turned into an aqueous composition by, for example, the following methods.
[Method 1] A method of partially or entirely neutralizing or quaternizing the hydrophilic group of the aqueous urethane resin obtained by a reaction between the polyol (a1) and the polyisocyanate (a2); then adding water to disperse the resin in water; and then causing chain extension with the chain extender to thereby achieve dispersion of the aqueous urethane resin (A) in water.
[Method 2] A method of charging, into a reaction vessel, all at once or in portions, the aqueous urethane resin obtained by a reaction between the polyol (a1) and the polyisocyanate (a2) and a chain extender that is similar to those described above; causing a chain extension reaction to produce the aqueous urethane resin (A); then partially or entirely neutralizing or quaternizing the hydrophilic group of the obtained aqueous urethane resin (A); and then adding water to disperse the resin in water.

In the [Method 1] and [Method 2], if necessary, an emulsifying agent may be used. During dissolution in water or dispersion in water, if necessary, a device such as a homogenizer may be used.

Examples of the emulsifying agent include nonionic emulsifying agents such as polyoxyethylene nonylphenyl ether, polyoxyethylene lauryl ether, polyoxyethylene styrylphenyl ether, polyoxyethylene sorbitol tetraoleate, and polyoxyethylene-polyoxypropylene copolymers; anionic emulsifying agents such as fatty acid salts including sodium oleate, alkyl sulfates, alkyl benzenesulfonates, alkyl sulfosuccinates, naphthalene sulfonate, polyoxyethylene alkyl sulfates, sodium alkane sulfonates, and sodium alkyl diphenyl ether sulfonates; cationic emulsifying agents such as alkylamine salts, alkyltrimethylammonium salts, and alkyldimethylbenzylammonium salts. In particular, in view of maintaining of high storage stability of a coating material according to the present invention, basically, an anionic or nonionic emulsifying agent is preferably used.

In an aqueous-urethane-resin-(A) aqueous dispersion in which the aqueous urethane resin (A) obtained by the above-described method is dispersed in the aqueous medium (D), the content ratio of the aqueous urethane resin (A) with respect to the total amount of the aqueous dispersion is preferably in the range of 10 to 50 for the purpose of enhancement of ease of production of a heat-sealing material according to the present invention and preparation of a heat-sealing material exhibiting high moisture-heat resistance and high adhesion to various base members.

The aqueous-urethane-resin-(A) aqueous dispersion may be an aqueous dispersion in which two or more aqueous urethane resins having different compositions are mixed. Specifically, two or more aqueous urethane resins in which polyols (a1) used for producing the aqueous urethane resins have different compositions can be used in combination.

Hereinafter, the aqueous polyolefin resin (B) used for producing a heat-sealing material according to the present invention will be described.

Examples of the aqueous polyolefin resin (B) used in the present invention include homopolymers and copolymers of ethylene, propylene, 1-butene, 1-pentene, 1-hexene, 1-heptene, 1-octene, and 1-nonene, that have the functional group [X]. Specifically, it is essential to use a polymer having the functional group [X] that can react with an epoxy group of the cross-linking agent (C) or an isocyanate group, the polymer being selected from, for example, polyethylene, polypropylene, polybutadiene, ethylene-propylene copolymers, natural rubber, synthetic isopropylene rubber, and ethylene-vinyl acetate copolymers. In the case where the aqueous polyolefin resin (B) is a copolymer, this copolymer may be a random copolymer or a block copolymer.

As with the functional group [X] of the aqueous urethane resin (A), the functional group [X] of the aqueous polyolefin resin (B) may be, for example, a carboxyl group; and, in particular, the functional group [X] is preferably a carboxyl group. Note that the functional group [X] may be the same functional group as a hydrophilic group of the aqueous polyolefin resin (B). Specifically, when a carboxyl group or a carboxylate group, which are anionic groups, is used as the hydrophilic group, the carboxyl group or the like may function as the functional group [X] during the cross-linking reaction.

The aqueous polyolefin resin (B) having a carboxyl group as the functional group [X] is preferably the so-called modified polyolefin resin such as a resin obtained by a reaction between the polyolefin resin exemplified above and an unsaturated carboxylic acid, a resin obtained by a reaction between such a polyolefin resin and a vinyl monomer, or a resin obtained by chlorination of such a polyolefin resin.

Regarding the functional group [X], for example, a carboxyl group can be introduced into the aqueous polyolefin resin (B) by a reaction between the polyolefin resin and an unsaturated dicarboxylic acid such as maleic acid (anhydride).

Examples of the unsaturated dicarboxylic acid include maleic acid, fumaric acid, itaconic acid, citraconic acid, anhydrides of the foregoing, and unsaturated dicarboxylic acid esters (butyl maleate, dibutyl maleate, butyl itaconate, and the like). One or more of these acids may be used. Of these, maleic anhydride is preferred.

The aqueous polyolefin resin (B) having been modified with such an unsaturated carboxylic acid preferably has an acid value in the range of 5 to 250 for the purpose of suppressing deterioration of the cured resin layer due to influences of heat, water (moisture), and the like and suppressing a decrease in the adhesion to various base members.

The modification of a polyolefin resin can be performed by, for example, heating the above-described polyolefin resin and an unsaturated dicarboxylic acid such as maleic acid to cause a reaction.

The aqueous polyolefin resin (B) preferably has a weight-average molecular weight of 20,000 to 500,000 for the purpose of suppressing deterioration of the cured resin layer due to influences of heat, water (moisture), and the like and suppressing a decrease in the adhesion to various base members. Note that the weight-average molecular weight denotes a value measured by gel permeation chromatography (GPC).

Hereinafter, the cross-linking agent (C) used in the present invention will be described.

In the present invention, as the cross-linking agent (C), the alkylated methylolmelamine resin (c1) is used as an essential component and the epoxy compound (c2) is used in combination with the alkylated methylolmelamine resin (c1). This is important for the purpose of obtaining a heat-sealing material that exhibits high moisture-heat resistance and high adhesion to various base members.

The alkylated methylolmelamine resin (c1) may be, for example, a resin obtained by a reaction between a methylolmelamine resin and a lower alcohol (alcohol having 1 to 6 carbon atoms) such as methyl alcohol or butyl alcohol. Specifically, for example, an imino-group-containing alkylated methylolmelamine resin or an amino-group-containing alkylated methylolmelamine resin may be used.

The methylolmelamine resin may be, for example, an amino-group-containing methylolmelamine resin obtained by condensation between melamine and formaldehyde, an imino-group-containing methylolmelamine resin, a trimethoxymethylolmelamine resin, or a hexamethoxymethylolmelamine resin; and, a trimethoxymethylolmelamine resin or a hexamethoxymethylolmelamine resin is preferably used.

The epoxy compound (c2) preferably has 2 to 5 epoxy groups, more preferably 3 or 4 epoxy groups.

Examples of the epoxy compound (c2) include bisphenol A epichlorohydrin epoxy resins, ethylene glycidyl ether, polyethylene glycol diglycidyl ether, glycerin diglycidyl ether, glycerin triglycidyl ether, 1,6-hexanediol glycidyl ether, trimethylolpropane triglycidyl ether, diglycidylaniline, diamineglycidylamine, N,N,N',N'-tetraglycidyl-m-xylylenediamine, and 1,3-bis(N,N'-diamineglycidylaminomethyl)cyclohexane.

In particular, the epoxy compound (c2) preferably has an epoxy equivalent of 100 to 300 for the purpose of imparting durability. Specifically, trimethylolpropane triglycidyl ether or glycerin triglycidyl ether is preferably used.

The epoxy compound (c2) is preferably an epoxy compound having a hydrolyzable silyl group for the purpose of suppressing deterioration of the cured resin layer due to influences of heat, water (moisture), and the like and suppressing a decrease in the adhesion to various base members.

The epoxy compound having a hydrolyzable silyl group may be, for example, 3-glycidoxypropyltrimethoxysilane, 3-glycidoxypropyltriethoxysilane, 3-glycidoxypropylmethyldiethoxysilane, 3-glycidoxypropylmethyldimethoxysilane, 2-(3,4-epoxycyclohexyl)ethyltrimethoxysilane, or 2-(3,4-epoxycyclohexyl)ethyltriethoxysilane.

In particular, the epoxy compound (c2) having a hydrolyzable silyl group is more preferably one or more selected from the group consisting of 3-glycidoxypropyltriethoxysilane, 3-glycidoxypropyltrimethoxysilane, 2-(3,4-epoxycyclohexyl)ethyltrimethoxysilane, and 2-(3,4-epoxycyclohexyl)ethyltriethoxysilane for the purpose of suppressing deterioration of the cured resin layer due to influences of heat, water (moisture), and the like and suppressing a decrease in the adhesion to various base members.

If necessary, the cross-linking agent (C) may contain, in addition to the alkylated methylolmelamine resin (c1) and the epoxy compound (c2) having a hydrolyzable silyl group, another cross-linking agent. Examples of the other cross-linking agent usable if necessary include isocyanate monomers such as tolylene diisocyanate, chlorophenylene diisocyanate, hexamethylene diisocyanate, tetramethylene diisocyanate, isophorone diisocyanate, diphenylmethane diisocyanate, and hydrogenated diphenylmethane diisocyanate; isocyanate compounds and isocyanurate compounds obtained by addition reactions of such isocyanate monomers with, for example, alcohol compounds having two or more hydroxyl groups such as trimethylolpropane; and isocyanate compounds such as biuret compounds.

Hereinafter, the aqueous medium (D) used in the present invention will be described.

Examples of the aqueous medium (D) used in the present invention include water, organic solvents miscible with water, and mixtures of the foregoing. Examples of the organic solvents miscible with water include alcohols such as methanol, ethanol, n- and isopropanol; ketones such as acetone and methyl ethyl ketone; polyalkylene glycols such as ethylene glycol, diethylene glycol, and propylene glycol; alkyl ethers of polyalkylene glycols; and lactams such as N-methyl-2-pyrrolidone. In the present invention, water alone may be used; a mixture of water and an organic solvent miscible with water may be used; or, only an organic solvent miscible with water may be used. In view of safety and environmental load, water alone or a mixture of water and an organic solvent miscible with water is preferred; in particular, water alone is preferred.

The content of the aqueous medium (D) with respect to the total mass of a heat-sealing material according to the present invention is preferably in the range of 30% by mass to 90% by mass for the purpose of enhancing, for example, the coating workability of a heat-sealing material according to the present invention and achieving both of adhesion and moisture-heat resistance.

A heat-sealing material according to the present invention can be produced by, for example, the following procedure: an aqueous dispersion of the aqueous urethane resin (A) produced by the above-described method, an aqueous dispersion of the aqueous polyolefin resin (B), and the cross-linking agent (C) are supplied all at once or in portions and mixed. Regarding the cross-linking agent (C), the alkylated methylolmelamine resin (c1) and the epoxy compound (c2) having a hydrolyzable silyl group may be mixed together in advance or may be independently mixed with the aqueous dispersion of the aqueous urethane resin (A) or the aqueous dispersion of the aqueous polyolefin resin (B).

If necessary, a heat-sealing material according to the present invention obtained by the above-described procedure may contain, in addition to the above-described components, for example, other additives.

Examples of the additives include antioxidants, light-resistant agents, plasticizers, film-forming aids, leveling agents, foaming agents, thickening agents, coloring agents, flame retardants, other aqueous resins, and various fillers. Such additives may be used as long as advantages of the present invention are not degraded.

Another additive such as a surfactant may be used in view of further enhancing the dispersion stability of a heat-sealing material according to the present invention. However, such a surfactant may degrade the adhesion or water resistance of the resultant films in some cases. Accordingly, the amount of the surfactant used is preferably in the range of 20 parts by mass or less with respect to the total mass (100 parts by mass) of the aqueous urethane resin (A) and the aqueous polyolefin resin (B). The amount of the surfactant used is preferably minimized.

A heat-sealing material according to the present invention can form a heat-sealing layer that exhibits high adhesion to base members and high moisture-heat resistance. In particular, a heat-sealing material according to the present invention exhibits high adhesion to both of a polar base member and a nonpolar base member. Accordingly, the heat-sealing material can be suitably used as a heat-sealing material for bonding together a polar base member and a nonpolar base member. Specifically, the heat-sealing material can be suitably used as a heat-sealing material for bonding together a nonpolar base member that can constitute a side (surface) opposite to the light-receiving surface of a solar cell, and a back sheet layer (polar base member) formed of polyethylene terephthalate, polypropylene, or the like; the nonpolar base member is formed of, for example, an ethylene-vinyl acetate copolymer, a polyvinylidene fluoride resin, a polyvinyl fluoride resin, an ethylene-vinyl alcohol copolymer, a polypropylene resin, polyvinyl butyral, or glass.

As for base members on which the heat-sealing layer can be formed, for example, there are various plastics, films thereof, metals, glass, paper, and wood. Specifically, an example of a polar base member is a polyethylene terephthalate base member. An example of a nonpolar base member is a base member formed of an ethylene-vinyl acetate copolymer, a polyvinylidene fluoride resin, a polyvinyl fluoride resin, an ethylene-vinyl alcohol copolymer, a polypropylene resin, polyvinyl butyral, glass, or the like.

A heat-sealing material according to the present invention may be used in the following case: the heat-sealing material is applied to a surface of a base member and dried to achieve cross-linking to some extent to form a resin layer; on the surface of the resin layer, another base member is placed; heating is performed to cause a reaction between a hydroxyl group generated by the cross-linking reaction and a hydrolyzable silyl group of the hydrolyzable-silyl-group-containing epoxy compound (c2) to thereby bond the base members together. The surface of the resin layer formed by the application to the surface of the base member and drying has substantially no tackiness prior to the heating. Accordingly, for example, a member in which the resin layer is formed in advance on a surface of one of base members may be stacked and stored.

On the other hand, on the surface of the heat-sealing layer in advance on a surface of the base member, the other base member is placed; and heating is performed to cause melting of the heat-sealing layer and a cross-linking reaction to thereby achieve strong bonding of the base members. The heat-sealing layer formed by the cross-linking reaction also has high moisture-heat resistance and hence deterioration of the heat-sealing layer due to influences of heat, water (moisture), and the like can be suppressed.

A method for coating a surface of a base member with a heat-sealing material according to the present invention is, for example, a spraying method, a curtain coater method, a flow coater method, a roll coater method, a brush coating method, or an immersion method.

In particular, in the case where a surface of a plastic film such as a polyethylene terephthalate film is coated with the heat-sealing material or the like, the following in-line coating method may be employed: while the plastic base member is biaxially drawn under a condition of about 200°C or less, the heat-sealing material is applied to a surface of the film and dried and a cross-linking reaction is caused to form a heat-sealing layer; and the film is subsequently drawn in the transverse direction.

Alternatively, in the case where a surface of a plastic film such as a polyethylene terephthalate film is coated with the heat-sealing material or the like, the following off-line coating method may be employed: such a plastic film obtained by the biaxial drawing is temporarily wound up in the form of a roll or the like; the plastic film is then released from the roll and a surface thereof is coated with the heat-sealing material or the like.

In the case where a surface of the plastic film is coated with the heat-sealing material or the like by the off-line coating method, drying and the like are preferably performed at a temperature of about 150°C or less, so that the dimension stability of the plastic film is not degraded.

By using such a method, a heat-sealing layer can be formed on a surface of a base member through cross-linking and curing of the heat-sealing material.

In addition, in the case where a heat-sealing material according to the present invention is applied to a surface of one of base members as described above to form a heat-sealing layer on the surface of the base member through cross-linking and curing of the heat-sealing material, the other base member is placed on the surface of the heat-sealing layer and heating is then performed at about 100°C to about 160°C under a decreased pressure or an increased pressure to thereby obtain a laminated body in which the base members are laminated.

This laminated body also has high moisture-heat resistance and hence can be used in various applications, for example, production of solar-cell modules (solar photovoltaic power generation apparatuses) and fixing of an interior material of automobiles. In particular, the laminated body can be suitably used for bonding together a nonpolar base member that can constitute a side (surface) opposite to the light-receiving surface of a solar cell, and a back sheet layer (nonpolar base member) formed of polyethylene terephthalate, polypropylene, or the like; the former nonpolar base member is formed of an ethylene-vinyl acetate copolymer, a polyvinylidene fluoride resin, a polyvinyl fluoride resin, an ethylene-vinyl alcohol copolymer, a polypropylene resin, polyvinyl butyral, glass, or the like.

In general, in such a solar-cell module, a back sheet layer formed of polyethylene terephthalate, polypropylene, or the like is commonly provided on a surface of a base member that is formed of an ethylene-vinyl acetate copolymer or the like and constitutes a surface on the side opposite to the light-receiving surface of the solar cell, for the purpose of suppressing, for example, deterioration of the base member. Such a module can be produced by, for example, the following procedure: a heat-sealing layer formed by curing of a heat-sealing material according to the present invention is provided on a surface of the base member that is formed of an ethylene-vinyl acetate copolymer and constitutes a surface on the side opposite to the light-receiving surface of the solar cell; and subsequently, on the heat-sealing layer, a back sheet layer formed of polyethylene terephthalate, polypropylene, or the like is formed.

Specifically, a laminate sheet having a heat-sealing layer formed by curing of the heat-sealing material on a surface of a sheet that is to form the back sheet layer and is formed of polyethylene terephthalate, polypropylene, or the like is prepared; the laminate sheet is placed on a surface of a base member that is formed of an ethylene-vinyl acetate copolymer and is on the side opposite to the light-receiving surface of the solar cell, such that the heat-sealing layer of the laminate sheet is in contact with the surface of the base member that is formed of an ethylene-vinyl acetate copolymer; and heating is performed to laminate together the laminate sheet and the base member.

A solar-cell module obtained by such a method exhibits high durability in terms of moisture-heat resistance and the like even in the case of outdoor usage for a long period of time.

### EXAMPLES

Hereinafter, the present invention will be specifically described with reference to Examples and Comparative examples.

### [Preparation example 1]

A reaction vessel equipped with a thermometer, a nitrogen gas inlet tube, and a stirrer was charged with, under introduction of nitrogen gas, 830 parts by mass of terephthalic acid, 830 parts by mass of isophthalic acid, 374 parts by mass of ethylene glycol, 604 parts by mass of neopentyl glycol, and 0.5 parts by mass of dibutyl tin oxide; and esterification was performed at 180°C to 230°C for 5 hours and then a polycondensation reaction was performed at 260°C for 6 hours until the acid value reached less than 1. Thus, a polyester polyol (a1') having an acid value of 0.2 and a hydroxyl value of 74.5 was obtained.

The polyester polyol (a1') (1000 parts by mass) was dehydrated at 100°C under a reduced pressure, then cooled to 80°C, mixed with 690 parts by mass of methyl ethyl ketone and sufficiently stirred and dissolved, mixed with 77 parts by mass of 2,2'-dimethylolpropionic acid, further mixed with 209 parts by mass of hexamethylene diisocyanate, and caused to react at 75°C for 8 hours.

After it was confirmed that the mass ratio of unreacted isocyanate groups remaining in the reaction mixture reached 0.1% by mass or less, the reaction mixture was cooled to 50°C, and mixed with 58 parts by mass of triethylamine and 5100 parts by mass of water. Under a reduced pressure, methyl ethyl ketone was removed at a temperature of 40°C to 60°C and water was added to adjust the concentration. As a result, a composition (I) having a non-volatile content of 20% by mass and containing an aqueous urethane resin having a weight-average molecular weight of 48300 and dispersed in water was obtained.

### [Preparation example 2]

In a reaction vessel equipped with a thermometer, a nitrogen gas inlet tube, and a stirrer, under introduction of nitrogen gas, 1000 parts by mass of NIPPOLLAN 980R (manufactured by Nippon Polyurethane Industry Co., Ltd., polycarbonatediol, number-average molecular weight: 2,000) was mixed, then cooled to 80°C, then mixed with 671 parts by mass of methyl ethyl ketone and sufficiently stirred and dissolved, mixed with 75 parts by mass of 2,2'-dimethylolpropionic acid and 178 parts by mass of hexamethylene diisocyanate, and caused to react at 75°C for 8 hours.

After it was confirmed that the mass ratio of unreacted isocyanate groups remaining in the reaction mixture reached 0.1% by mass or less, the reaction mixture was cooled to 50°C, and mixed with 68 parts by mass of triethylamine and 5000 parts by mass of water. Under a reduced pressure, methyl ethyl ketone was removed at a temperature of 40°C to 60°C and water was added to adjust the concentration. As a result, a composition (II) having a non-volatile content of 20% by mass and containing an aqueous urethane resin having a weight-average molecular weight of 56700 and dispersed in water was obtained.

### [Preparation example 3]

To a reaction vessel equipped with a thermometer, a nitrogen gas inlet tube, and a stirrer, under introduction of nitrogen gas, 1000 parts by mass of POLESTAR VS-1236 (manufactured by SEIKO PMC CORPORATION, water dispersion of maleic-anhydride-modified polyolefin, weight-average molecular weight: 70000) was added, stirred at 80°C for 3 hours to be melted, then cooled to 50°C, mixed with 180 parts by mass of triethylamine to thereby be neutralized, and then mixed with 2153 parts by mass of water to thereby be dissolved in water. As a result, a composition (III) having a non-volatile content of 30% by mass was obtained.

### [Example 1]

The composition (I) (100 parts by mass) obtained in the Preparation example 1 was mixed with 44 parts by mass of the composition (III) obtained in the Preparation example 3. Subsequently, 7 parts by mass of BECKAMINE M-3 (manufactured by DIC Corporation, trimethoxymethylol melamine resin, non-volatile content: 80% by mass) and 8 parts by mass of WATERSOL WSA-950 (manufactured by DIC Corporation, epoxy compound having hydrolyzable silyl group, non-volatile content: 100% by mass) were added. The resultant mixture was stirred and mixed with water. As a result, a heat-sealing material (X-1) composed of an aqueous resin composition (X-1) having a non-volatile content of 20% by mass was obtained.

### [Example 2]

The same procedure was performed as in Example 1 except that 100 parts by mass of the composition (I) obtained in the Preparation example 1 was replaced by 100 parts by mass of the composition (II) obtained in the Preparation example 2. Thus, a heat-sealing material (X-2) composed of an aqueous resin composition (X-2) was obtained.

### [Example 3]

The same procedure was performed as in Example 1 except that the amount of BECKAMINE M-3 (manufactured by DIC Corporation, trimethoxymethylol melamine resin, non-volatile content: 80% by mass) was changed from 7 parts by mass to 2 parts by mass. Thus, a heat-sealing material (X-3) composed of an aqueous resin composition (X-3) was obtained.

### [Example 4]

The same procedure was performed as in Example 1 except that the amount of WATERSOL WSA-950 (manufactured by DIC Corporation, epoxy compound having hydrolyzable silyl group, non-volatile content: 80% by mass) was changed from 8 parts by mass to 16 parts by mass. Thus, a heat-sealing material (X-4) composed of an aqueous resin composition (X-4) was obtained.

### [Example 5]

The same procedure was performed as in Example 1 except that the amount of WATERSOL WSA-950 (manufactured by DIC Corporation, epoxy compound having hydrolyzable silyl group, non-volatile content: 80% by mass) was changed from 8 parts by mass to 2 parts by mass. Thus, a heat-sealing material (X-5) composed of an aqueous resin composition (X-5) was obtained.

### [Example 6]

The composition (I) (72 parts by mass) obtained in the Preparation example 1 and 72 parts by mass of the composition (III) obtained in the Preparation example 3 were mixed and stirred. Subsequently, 7 parts by mass of BECKAMINE M-3 (manufactured by DIC Corporation, trimethoxymethylol melamine resin, non-volatile content: 80% by mass) and 10 parts by mass of WATERSOL WSA-950 (manufactured by DIC Corporation, epoxy compound having hydrolyzable silyl group, non-volatile content: 100% by mass) were added and mixed. Water was added. As a result, a heat-sealing material (X-6) composed of an aqueous resin composition (X-6) having a non-volatile content of 20% by mass was obtained.

### [Example 7]

The same procedure was performed as in Example 1 except that 100 parts by mass of the composition (I) obtained in the Preparation example 1 was replaced by 50 parts by mass of the composition (I) obtained in the Preparation example 1 and 50 parts by mass of the composition (II) obtained in the Preparation example 2. Thus, a heat-sealing material (X-7) composed of an aqueous resin composition (X-7) was obtained.

### [Example 8]

The same procedure was performed as in Example 1 except that 7 parts by mass of BECKAMINE M-3 (manufactured by DIC Corporation, trimethoxymethylol melamine resin, non-volatile content: 80% by mass) was replaced by 7 parts by mass of BECKAMINE J-101 (manufactured by DIC Corporation, hexamethoxymethylol melamine resin, non-volatile content: 80% by mass). Thus, a heat-sealing material (X-8) composed of an aqueous resin composition (X-8) was obtained.

### [Example 9]

The same procedure was performed as in Example 1 except that 8 parts by mass of WATERSOL WSA-950 (manufactured by DIC Corporation, epoxy compound having hydrolyzable silyl group, non-volatile content: 100% by mass) was replaced by 5 parts by mass of Denacol EX-321 (manufactured by Nagase ChemteX Corporation, trimethylolpropane polyglycidyl ether, non-volatile content: 100% by mass). Thus, a heat-sealing material (X'-9) composed of an aqueous resin composition (X-9) was obtained.

### [Comparative example 1]

The composition (I) (100 parts by mass) obtained in the Preparation example 1 was mixed with 44 parts by mass of the composition (III) obtained in the Preparation example 3, stirred, and mixed with water. As a result, a heat-sealing material (X'-1) composed of an aqueous resin composition (X'-1) having a non-volatile content of 20% by mass was obtained.

### [Comparative example 2]

The composition (I) (100 parts by mass) obtained in the Preparation example 1 and 44 parts by mass of the composition (III) obtained in the Preparation example 3 were mixed and stirred. Subsequently, the resultant mixture was mixed with 8 parts by mass of WATERSOL WSA-950 (manufactured by DIC Corporation, epoxy compound having hydrolyzable silyl group, non-volatile content: 100% by mass) and mixed with water. As a result, a heat-sealing material (X'-2) composed of an aqueous resin composition (X'-2) having a non-volatile content of 20% by mass was obtained.

### [Comparative example 3]

The composition (I) (100 parts by mass) obtained in the Preparation example 1 and 44 parts by mass of the composition (III) obtained in the Preparation example 3 were mixed and stirred. Subsequently, the resultant mixture was mixed with 7 parts by mass of BECKAMINE M-3 (manufactured by DIC Corporation, trimethoxymethylol melamine resin, non-volatile content: 80% by mass) and mixed with water. As a result, a heat-sealing material (X'-3) composed of an aqueous resin composition (X'-3) having a non-volatile content of 20% by mass was obtained.

### [Comparative example 4]

The composition (I) (144 parts by mass) obtained in the Preparation example 1 was mixed with 7 parts by mass of BECKAMINE M-3 (manufactured by DIC Corporation, trimethoxymethylol melamine resin, non-volatile content: 80% by mass) and 3 parts by mass of WATERSOL WSA-950 (manufactured by DIC Corporation, epoxy compound having hydrolyzable silyl group, non-volatile content: 100% by mass), stirred, and mixed with water. As a result, a heat-sealing material (X'-4) composed of an aqueous resin composition (X'-4) having a non-volatile content of 20% by mass was obtained.

### [Comparative example 5]

The composition (III) (144 parts by mass) obtained in the Preparation example 3 was mixed with 7 parts by mass of BECKAMINE M-3 (manufactured by DIC Corporation, trimethoxymethylol melamine resin, non-volatile content: 80% by mass) and 18 parts by mass of WATERSOL WSA-950 (manufactured by DIC Corporation, epoxy compound having hydrolyzable silyl group, non-volatile content: 100% by mass), stirred, and mixed with water. As a result, a heat-sealing material (X'-5) composed of an aqueous resin composition (X'-5) having a non-volatile content of 20% by mass was obtained.

### [Comparative example 6]

The same procedure was performed as in Example 1 except that 8 parts by mass of WATERSOL WSA-950 (manufactured by DIC Corporation, epoxy resin having hydrolyzable silyl group, non-volatile content: 100% by mass) was replaced by 8 parts by mass of AQUANATE 210 (manufactured by Nippon Polyurethane Industry Co., Ltd., water-dispersible polyisocyanate cross-linking agent, non-volatile content: 100% by mass). Thus, a heat-sealing material (X'-7) composed of an aqueous resin composition (X'-7) was obtained.

### [Comparative example 7]

The same procedure was performed as in Example 1 except that 7 by mass of WATERSOL WSA-950 (manufactured by DIC Corporation, epoxy compound having hydrolyzable silyl group, non-volatile content: 100% by mass) was replaced by 8 parts by mass of AQUANATE 210 (manufactured by Nippon Polyurethane Industry Co., Ltd., water-dispersible polyisocyanate cross-linking agent, non-volatile content: 100% by mass). Thus, a heat-sealing material (X'-8) composed of an aqueous resin composition (X'-8) was obtained.

### [Comparative example 8]

The same procedure was performed as in Example 1 except that 8 parts by mass of WATERSOL WSA-950 (manufactured by DIC Corporation, epoxy compound having hydrolyzable silyl group, non-volatile content: 100% by mass) was replaced by 30 parts by mass of HYDRAN ASSISTOR CS-7 (manufactured by DIC Corporation, water-dispersible carbodiimide compound, non-volatile content: 40% by mass). Thus, a heat-sealing material (X'-9) composed of an aqueous resin composition (X'-9) was obtained.

### [Comparative example 9]

The same procedure was performed as in Example 1 except that 7 parts by mass of WATERSOL WSA-950 (manufactured by DIC Corporation, epoxy compound having hydrolyzable silyl group, non-volatile content: 100% by mass) was replaced by 5 parts by mass of CR-5L (manufactured by DIC Corporation, water-soluble epoxy compound, non-volatile content: 100% by mass), and 8 parts by mass of WATERSOL WSA-950 (manufactured by DIC Corporation, epoxy compound having hydrolyzable silyl group, non-volatile content: 100% by mass) was replaced by 8 parts by mass of AQUANATE 210 (manufactured by Nippon Polyurethane Industry Co., Ltd., water-dispersible polyisocyanate cross-linking agent, non-volatile content: 100% by mass). Thus, a heat-sealing material (X'-10) composed of an aqueous resin composition (X'-10) was obtained.

### [Comparative example 10]

The same procedure was performed as in Example 1 except that the amount of BECKAMINE M-3 (manufactured by DIC Corporation, trimethoxymethylol melamine resin, non-volatile content: 80% by mass) was changed from 7 parts by mass to 2 parts by mass. Thus, a heat-sealing material (X'-11) composed of an aqueous resin composition (X'-11) was obtained.

### [Comparative example 11]

The same procedure was performed as in Example 1 except that the amount of BECKAMINE M-3 (manufactured by DIC Corporation, trimethoxymethylol melamine resin, non-volatile content: 80% by mass) was changed from 7 parts by mass to 23 parts by mass. Thus, a heat-sealing material (X'-12) composed of an aqueous resin composition (X'-12) was obtained.

### [Comparative example 12]

The same procedure was performed as in Example 1 except that the amount of WATERSOL WSA-950 (manufactured by DIC Corporation, epoxy compound having hydrolyzable silyl group, non-volatile content: 100% by mass) was changed from 8 parts by mass to 46 parts by mass. Thus, a heat-sealing material (X'-12) composed of an aqueous resin composition (X'-12) was obtained.

### [Comparative example 13]

The same procedure was performed as in Example 1 except that the amount of WATERSOL WSA-950 (manufactured by DIC Corporation, epoxy compound having hydrolyzable silyl group, non-volatile content: 100% by mass) was changed from 8 parts by mass to 1 part by mass. Thus, a heat-sealing material (X'-13) composed of an aqueous resin composition (X'-13) was obtained.

### [Evaluation method in terms of adhesion to polar base member and nonpolar base member]

Each of the heat-sealing materials obtained in Examples and Comparative examples above was applied to a surface of a polyethylene terephthalate film, which is a polar base member, such that the thickness of the dried film was to be 5 µm, and dried at 150°C for 5 minutes. As a result, a laminated body in which a cross-linked cured resin layer (heat-sealing layer) was provided on the surface of the film was obtained.

On the surface of the cured resin layer (heat-sealing layer) of the laminated body, a film (length 5 cm x width 1 cm) that was formed of ethylene-vinyl acetate and served as a nonpolar base member was placed. Subsequently, the laminated body and the film were press-bonded together with a vacuum press-bonding apparatus at 150°C for 15 minutes. As a result, a laminated body was obtained in which the polyethylene terephthalate film and the polyolefin film were bonded together with the cured resin layer (heat-sealing layer) therebetween.

### [Test method in terms of adhesion]

The adhesion of the laminated body immediately after being produced by the above-described method was evaluated with a tensile testing machine (Autograph manufactured by SHIMADZU CORPORATION) in accordance with the T-type peel test (1000 N cell). The adhesion was evaluated on the basis of the adhesion between the heat-sealing layer and the film formed of ethylene-vinyl acetate.

As a result of measurement performed by the above-described method, a laminated body having a peel strength of about 30 N/cm or more was evaluated as having high adhesion and a laminated body having a peel strength of 35 N/cm or more was evaluated as having very high adhesion.

### [Evaluation in terms of moisture-heat resistance]

The laminated body obtained above was subjected to a wet heat test by being left to stand in a thermo-hygrostat set under conditions of 120°C x 100% RH for 72 hours. The adhesion of the laminated body having been left to stand was measured and evaluated by the same method as above.

As a result of measurement performed by the above-described method, a laminated body having a peel strength of about 25 N/cm or more was evaluated as having high adhesion and a laminated body having a peel strength of 35 N/cm or more was evaluated as having very high adhesion.

In addition, a laminated body in which a ratio (retention ratio) of the peel strength of the laminated body after the wet heat test to the peel strength of the laminated body immediately after the production was about 50% or more was evaluated as having high moisture-heat resistance. A laminated body in which the retention ratio was 75% or more was evaluated as having very high moisture-heat resistance.

**[Table 1]**

| Table 1 | Example 1 | Example 2 | Example 3 | Example 4 | Example 5 |
|---|---|---|---|---|---|
| [Aqueous urethane resin/Aqueous polyolefin resin] (mass ratio) | 60/40 | 60/40 | 60/40 | 60/40 | 60/40 |
| Composition (I) [parts by mass] | 100 | 0 | 100 | 100 | 100 |
| Composition (II) [parts by mass] | 0 | 100 | 0 | 0 | 0 |
| Composition (III) [parts by mass] | 44 | 44 | 44 | 44 | 44 |

| Alkylated methylolmelamine resin (c1) | | | | | |
|---|---|---|---|---|---|
| M-3 [parts by mass] | 7 | 7 | 3 | 7 | 7 |

| Epoxy compound (c2) | | | | | |
|---|---|---|---|---|---|
| WSA-950 [parts by mass] | 8 | 8 | 8 | 16 | 2 |
| [Amount of substance of epoxy group/Total amount of substance of functional group [X]] | 1.0/1.0 | 1.0/1.0 | 1.0/1.0 | 2.1/1.0 | 0.3/1.0 |
| Content of alkylated methylolmelamine resin (c1) [% by mass] | 16.9 | 16.9 | 7.2 | 16.9 | 16.9 |
| Adhesion (peel strength) [N/cm] | 40 | 40 | 40 | 50 | 35 |
| Moisture-heat resistance (peel strength after wet heat test) [N/cm] | 40 | 35 | 25 | 25 | 25 |
| Retention ratio (%) | 100 | 87.5 | 50 | 50 | 71 |

**[Table 2]**

| Table 2 | Example 6 | Example 7 | Example 8 | Example 9 |
|---|---|---|---|---|
| [Aqueous urethane resin/Aqueous polyolefin resin] (mass ratio) | 40/60 | 60/40 | 60/40 | 60/40 |
| Composition (I) [parts by mass] | 72 | 50 | 100 | 100 |
| Composition (II) [parts by mass] | 0 | 50 | 0 | 0 |
| Composition (III) [parts by mass] | 72 | 44 | 44 | 44 |

| Alkylated methylolmelamine resin (c1) | | | | |
|---|---|---|---|---|
| M-3 [parts by mass] | 7 | 7 | 0 | 7 |
| J-101 [parts by mass] | 0 | 0 | 7 | 0 |

| Epoxy compound (c2) | | | | |
|---|---|---|---|---|
| WSA-950 [parts by mass] | 10 | 8 | 8 | 0 |
| EX-321 [parts by mass] | 0 | 0 | 0 | 5 |
| [Amount of substance of epoxy group/Total amount of substance of functional group [X]] | 1.0/1.0 | 1.2/1.0 | 1.2/1.0 | 1.0/1.0 |
| Content of alkylated methylolmelamine resin (c1) [% by mass] | 15.6 | 16.9 | 16.9 | 16.9 |
| Adhesion (peel strength) [N/cm] | 30 | 40 | 40 | 55 |
| Moisture-heat resistance (peel strength after wet heat test) [N/cm] | 30 | 38 | 40 | 35 |
| Retention ratio (%) | 100 | 95 | 100 | 70 |

**[Table 3]**

| Table 3 | Comparative example 1 | Comparative example 2 | Comparative example 3 | Comparative example 4 | Comparative example 5 |
|---|---|---|---|---|---|
| [Aqueous urethane resin/Aqueous polyolefin resin] (mass ratio) | 60/40 | 60/40 | 60/40 | 100/0 | 0/100 |
| Composition (I) [parts by mass] | 100 | 100 | 100 | 144 | 0 |
| Composition (II) [parts by mass] | 0 | 0 | 0 | 0 | 0 |
| Composition (III) [parts by mass] | 44 | 44 | 44 | 0 | 144 |
| M-3 [parts by mass] | 0 | 0 | 7 | 7 | 7 |
| WSA-950 [parts by mass] | 0 | 8 | 0 | 3 | 18 |
| [Amount of substance of epoxy group/Total amount of substance of functional group [X]] | 0 | 1.2/1.0 | 0 | 1.0/1.0 | 1.0/1.0 |
| Content of alkylated methylolmelamine resin (c1)[% by mass] | 0 | 0 | 16.9 | 19.4 | 13.0 |
| Adhesion (peel strength) [N/cm] | 1 | 40 | 40 | 1 | 1 |
| Moisture-heat resistance (peel strength after wet heat test) [N/cm] | 1 | 10 | 10 | 1 | 1 |
| Retention ratio (%) | 100 | 25 | 25 | 100 | 100 |

**[Table 4]**

| Table 4 | Comparative example 6 | Comparative example 7 | Comparative example 8 | Comparative example 9 | Comparative example 10 |
|---|---|---|---|---|---|
| [Aqueous urethane resin/Aqueous polyolefin resin] (mass ratio) | 60/40 | 60/40 | 60/40 | 60/40 | 60/40 |
| Composition (I) [parts by mass] | 100 | 100 | 100 | 100 | 100 |
| Composition (II) [parts by mass] | 0 | 0 | 0 | 0 | 0 |
| Composition (III) [parts by mass] | 44 | 44 | 44 | 44 | 44 |
| M-3 [parts by mass] | 7 | 0 | 7 | 0 | 2 |
| WSA-950 [parts by mass] | 0 | 8 | 0 | 0 | 8 |
| CR-5L [parts by mass] | 0 | 0 | 0 | 5 | 0 |
| AQUANATE 210 [parts by mass] | 8 | 8 | 0 | 8 | 0 |
| CS-7 [parts by mass] | 0 | 0 | 30 | 0 | 0 |
| [Amount of substance of epoxy group/Total amount of substance of functional group [X]] | 1.0/1.0 | 1.0/1.0 | 0 | 1.0/1.0 | 1.0/1.0 |
| Content of alkylated methylolmelamine resin (c1) [% by mass] | 16.9 | 0 | 16.9 | 0 | 4.8 |
| Adhesion (peel strength) [N/cm] | 30 | 30 | 30 | 30 | 40 |
| Moisture-heat resistance (peel strength after wet heat test) [N/cm] | 15 | 5 | 1 | 1 | 15 |
| Retention ratio (%) | 50 | 16.7 | 3.3 | 3.3 | 37.5 |

**[Table 5]**

| Table 5 | Comparative example 11 | Comparative example 12 | Comparative example 13 |
|---|---|---|---|
| [Aqueous urethane resin/Aqueous polyolefin resin] (mass ratio) | 60/40 | 60/40 | 60/40 |
| Composition (I) [parts by mass] | 100 | 100 | 100 |
| Composition (II) [parts by mass] | 0 | 0 | 0 |
| Composition (III) [parts by mass] | 44 | 44 | 44 |
| M-3 [parts by mass] | 23 | 7 | 7 |
| WSA-950 [parts by mass] | 8 | 46 | 1 |
| CR-5L [parts by mass] | 0 | 0 | 0 |
| AQUANATE 210 [parts by mass] | 0 | 0 | 0 |
| CS-7 [parts by mass] | 0 | 0 | 0 |
| [Amount of substance of epoxy group/Total amount of substance of functional group [X]] | 1.0/1.0 | 6.0/1.0 | 1.0/6.0 |
| Content of alkylated methylolmelamine resin (c1) [% by mass] | 55.4 | 16.9 | 16.9 |
| Adhesion (peel strength) [N/cm] | 10 | 10 | 40 |
| Moisture-heat resistance (peel strength after wet heat test) [N/cm] | 1 | 1 | 10 |
| Retention ratio (%) | 10 | 10 | 25 |

The abbreviations in Tables 1 to 5 will be described.
"M-3": BECKAMINE M-3 (manufactured by DIC Corporation, trimethoxymethylol melamine resin, non-volatile content: 80% by mass)
"WSA-950": WATERSOL WSA-950 (manufactured by DIC Corporation, epoxy resin having hydrolyzable silyl group, non-volatile content: 100% by mass)
"CR-5L": CR-5L (manufactured by DIC Corporation, water-soluble epoxy compound, non-volatile content: 100% by mass)
"AQUANATE 210": AQUANATE 210 (manufactured by Nippon Polyurethane Industry Co., Ltd., water-dispersible polyisocyanate cross-linking agent, non-volatile content: 100% by mass)
"J-101": BECKAMINE J-101 (manufactured by DIC Corporation, hexamethoxymethylol melamine resin, non-volatile content: 80% by mass)
"CS-7": HYDRAN ASSISTER CS-7 (manufactured by DIC Corporation, water-dispersible carbodiimide compound, non-volatile content: 40% by mass)
"Content of alkylated methylolmelamine resin (c1) [% by mass]" denotes the mass ratio of the alkylated methylolmelamine resin to the total mass of the aqueous urethane resin and the aqueous polyolefin resin.

"Retention ratio (%)" denotes a ratio (retention ratio) of the peel strength of a laminated body after the wet heat test to the peel strength of the laminated body immediately after the production.

It has been demonstrated that the heat-sealing material obtained in Example 1 exhibits high adhesion and moisture-heat resistance. Compared with the heat-sealing material containing an aqueous urethane resin having a polyester structure (Example 1), the heat-sealing material obtained in Example 2 and having a polycarbonate structure in the aqueous urethane resin has slightly low moisture-heat resistance; however, this heat-sealing material has characteristics sufficient for practical usage. The heat-sealing material described in Example 3 in which the content of the alkylated methylolmelamine resin (c1) is slightly low has high adhesion but relatively low moisture-heat resistance; however, this heat-sealing material has characteristics sufficient for practical usage. Both of the heat-sealing material described in Example 4 in which the content of the epoxy compound (c2) is high and the heat-sealing material described in Example 5 in which the content of the epoxy compound (c2) is low have high adhesion and moisture-heat resistance.

The heat-sealing material described in Example 6 in which the mass ratio of the aqueous urethane resin to the aqueous polyolefin resin is out of the preferred range has high adhesion and moisture-heat resistance, but has relatively low adhesion. The heat-sealing material in which the aqueous urethane resin having a polycarbonate structure and the aqueous urethane resin having a polyester structure are mixed has relatively low moisture-heat resistance due to the influence of the miscibility of the aqueous urethane resins. It has been demonstrated that the heat-sealing material described in Example 8 in which the alkylated methylolmelamine resin (c1) is a compound different from that in Example 1 exhibits high adhesion and moisture-heat resistance. The heat-sealing material described in Example 9 in which the epoxy compound (c2) is a compound different from that in Example 1 exhibits high adhesion and relatively high moisture-heat resistance.

On the other hand, the heat-sealing material that is described in Comparative example 1 and does not contain the cross-linking agent (C) has very low adhesion and moisture-heat resistance and is not sufficient for practical usage. Both of the heat-sealing material that is described in Comparative example 2 and does not contain the alkylated methylolmelamine resin (c1) and the heat-sealing material that is described in Comparative example 3 and does not contain the epoxy compound (c2) have high adhesion but undergo a considerable decrease in the adhesion after the wet heat test and hence are not sufficient for practical usage. Both of the heat-sealing material that is described in Comparative example 4 and does not contain any aqueous polyolefin resin and the heat-sealing material that is described in Comparative example 5 and does not contain any aqueous urethane resin are insufficient in terms of adhesion and moisture-heat resistance.

In addition, the heat-sealing materials described in Comparative examples 6 and 9 in which the isocyanate cross-linking agent is used instead of the epoxy compound (c2), the heat-sealing material described in Comparative example 7 in which the isocyanate cross-linking agent is used instead of the alkylated methylolmelamine resin (c1), and the heat-sealing material described in Comparative example 8 in which the carbodiimide cross-linking agent is used instead of the epoxy compound (c2) are not sufficient for practical usage because these heat-sealing materials have high adhesion but undergo a considerable decrease in the adhesion after the wet heat test.

In addition, the heat-sealing materials described in Comparative examples 10 and 11 in which the content of the alkylated methylolmelamine resin (c1) is out of the predetermined range are not sufficient for practical usage because these heat-sealing materials undergo a considerable decrease in the adhesion after the wet heat test.

In addition, the heat-sealing materials described in Comparative examples 12 and 13 in which the ratio [Amount of substance of epoxy group/Total amount of substance of functional group [X]] is out of the predetermined range are not sufficient for practical usage in terms of adhesion and moisture-heat resistance.

## Claims

1. A heat-sealing material comprising an aqueous urethane resin (A), an aqueous polyolefin resin (B), a cross-linking agent (C), and an aqueous medium (D), wherein the cross-linking agent (C) contains an alkylated methylolmelamine resin (c1) and an epoxy compound (c2); a content of the alkylated methylolmelamine resin (c1) with respect to a total mass of the aqueous urethane resin (A) and the aqueous polyolefin resin (B) is in a range of 5% by mass to 50% by mass; one or both of the aqueous urethane resin (A) and the aqueous polyolefin resin (B) have a functional group [X] that is capable of reacting with an epoxy group; and a ratio of an amount of substance of an epoxy group of the epoxy compound (c2) to a total amount of substance of the functional group [X] [amount of substance of epoxy group/total amount of substance of functional group [X]] is 5/1 to 1/5.

2. The heat-sealing material according to Claim 1, wherein the functional group [X], which is present in one or both of the aqueous urethane resin (A) and the aqueous polyolefin resin (B), is at least one selected from the group consisting of a carboxyl group, a hydroxyl group, and an amino group.

3. The heat-sealing material according to Claim 1, wherein the aqueous urethane resin (A) is obtained by a reaction between a polyisocyanate (a2) and a polyol (a1) containing at least one selected from the group consisting of aromatic-ring-structure-containing polyester polyols and polycarbonate polyols.

4. The heat-sealing material according to Claim 1, wherein the epoxy compound (c2) is an epoxy compound having a hydrolyzable silyl group, trimethylolpropane polyglycidyl ether, or glycerin triglycidyl ether.

5. A laminated body obtained by applying the heat-sealing material according to any one of Claims 1 to 4 onto a surface of a polar base member (I) and drying the heat-sealing material to form a heat-sealing layer, placing a nonpolar base member (II) on a surface of the heat-sealing layer, and subsequently performing heating at 80°C to 180°C.

6. The laminated body according to Claim 5, wherein the polar base member (I) is a polyethylene terephthalate base member, a polypropylene base member, a polycarbonate base member, or a polyamide base member; and the nonpolar base member (II) is formed of an ethylene-vinyl acetate copolymer.

7. A method for producing a laminated body, comprising applying the heat-sealing material according to any one of Claims 1 to 4 onto a surface of a polar base member (I) and drying the heat-sealing material to cause a reaction between the functional group [X], which is present in one or both of the aqueous urethane resin (A) and the aqueous polyolefin resin (B), and the epoxy group of the epoxy compound (c2),
and to cause a self-cross-linking reaction in the alkylated methylolmelamine resin (c1) and/or
a reaction between the alkylated methylolmelamine resin (c1) and a hydroxyl group generated by the reaction between the functional group [X] and the epoxy compound (c2) to form a heat-sealing layer; subsequently placing a nonpolar base member (II) on a surface of the heat-sealing layer; and subsequently performing heating at 80°C to 180°C to bond together the polar base member (I) and the nonpolar base member (II).

8. A solar-cell module comprising a heat-sealing layer formed from the heat-sealing material according to any one of Claims 1 to 4 on a surface of a base member formed of an ethylene-vinyl acetate copolymer, the surface being on a side opposite to a light-receiving surface of a solar cell; and, on the heat-sealing layer, a back sheet layer including a polyethylene terephthalate base member, a polypropylene base member, a polycarbonate base member, or a polyamide base member.

9. A method for producing a solar-cell module, comprising placing a laminated sheet including, on a surface of a sheet including a polyethylene terephthalate base member, a polypropylene base member, a polycarbonate base member, or a polyamide base member, a heat-sealing layer formed from the heat-sealing material according to any one of Claims 1 to 4,
on a surface of a base member that is formed of an ethylene-vinyl acetate copolymer and constitutes a surface of a solar cell on a side opposite to a light-receiving surface of the solar cell,
such that the heat-sealing layer of the laminated sheet is in contact with the surface of the base member formed of the ethylene-vinyl acetate copolymer; and performing heating.
